# FASCICULE DE BREVET EUROPEEN

(11) **EP 1 485 226 B1**
(45) Date de publication et mention de la délivrance du brevet: **07.09.2005**
(21) Numéro de dépôt: 02804647.2
(22) Date de dépôt: 10.12.2002
(51) Int. Cl.: B23K 20/02

(54) **MODULE ELECTRONIQUE A FAIBLE COUT ET PROCEDE DE FABRICATION D'UN TEL MODULE**
KOSTENGÜNSTIGES ELEKTRONISCHES MODUL UND HERSTELLUNGSVERFAHREN DAFÜR
LOW-COST ELECTRONIC MODULE AND METHOD FOR MAKING SAME

(30) Priorité: 11.12.2001 CH 225801
(43) Date de publication de la demande: 15.12.2004
(73) Titulaire: Nagraid SA, 2301 La Chaux-de-Fonds (CH)
(72) Inventeur: DROZ, François, CH-2300 La Chaux-de-Fonds (CH)
(74) Mandataire: Wenger, Joel-Théophile
(86) Numéro de dépôt international: PCT/IB2002/005291
(87) Numéro de publication internationale: WO 2003/049894

(56) Documents cités:
- DE-C- 19 516 250
- US-A- 5 637 925
- US-A- 5 678 287
- US-A- 5 904 992

## Description

La présente invention est du domaine des modules électroniques et des procédés de fabrication desdits modules comprenant une pluralité de couches formées par des feuilles superposées et au moins un composant électronique.

L'invention concerne des modules fabriqués par pressage et thermoformage de différentes couches successives, ces modules comprenant au moins un composant électronique défini ici comme un élément tel qu'une bobine connectée à une puce le plus souvent appelé transpondeur.

Des modules connus comme des cartes à puces, des étiquettes électroniques ou des circuits électroniques sont fabriqués par assemblage de plusieurs feuilles pour former des couches superposées, à savoir un support appelé substrat, une couche conductrice et des feuilles de protection recouvrant les faces du module. Le composant électronique fixé sur le substrat est connecté aux pistes de la couche conductrice. Toutes ces feuilles sont assemblées soit par thermo-collage au moyen d'une presse, soit par laminage.

D'autres modules sont réalisés par enrobage d'un circuit électronique au moyen d'un liant. Après durcissement du liant, les faces du module sont, en général, recouvertes de feuilles de protection servant de décor.

Les procédés de fabrication des deux types de modules cités ci-dessus comportent un nombre élevé d'opérations délicates, longues et coûteuses exigeant un outillage complexe. De plus, la fabrication en très grandes séries de modules demande une rationalisation très poussée de tous les processus avec un taux de déchets minimal. Les produits finaux doivent être bon marché tout en étant fiables jusqu'au terme de leur durée de vie.

Le but de la présente invention est de proposer un procédé de fabrication de modules électroniques de rentabilité élevée. Plus particulièrement, ce procédé se distingue par des étapes nécessitant un outillage simplifié permettant une fabrication rapide d'une très grande quantité de modules.

La présente invention a également pour but d'obtenir un module électronique fiable tout en ayant un coût final très bas.

Ce but est atteint par un procédé de fabrication d'un module électronique comprenant au moins un composant électronique transporté sur un plateau servant à la manutention de composants électroniques et comportant des alvéoles, et d'une seconde feuille isolante caractérisé par les étapes suivantes:
- poser sur une surface de travail le plateau alvéolaire formant une première feuille isolante, lesdites alvéoles contenant chacune au moins un composant électronique,
- superposer la seconde feuille isolante sur la première de manière à fermer les alvéoles contenant le composant électronique,
- découper les modules suivant un contour englobant au moins une alvéole de la première feuille isolante.

Les composants électroniques, en général des transpondeurs, sont livrés par le fournisseur dans un conditionnement dont l'élément de base est un plateau constitué par une feuille isolante thermo-formée. Ce plateau, servant au transport et à la manutention des composants, comporte des alvéoles régulièrement réparties sur sa surface. En général, une alvéole contient un composant.

L'utilisation d'un tel élément du conditionnement des composants réduit considérablement le nombre d'opérations du procédé de fabrication des modules. En effet, les étapes préalables de préparation de la première feuille, les manipulations et le positionnement des transpondeurs qui peuvent s'avérer délicats ne sont plus nécessaires. La première étape du procédé consistera donc à superposer une seconde feuille isolante sur la première de manière à fermer toutes les alvéoles contenant un composant. Ensuite, cet assemblage est pressé à chaud au moyen d'une plaque de pressage appliquée sur la seconde feuille isolante pour former une plaque incorporant un grand nombre de composants. Cette plaque sera découpée afin d'obtenir des modules isolés comprenant au moins un composant.

Selon une variante du procédé, une matière de remplissage, constituée par exemple d'une résine, est introduite dans les alvéoles de la première feuille isolante de manière à enrober le composant électronique avant la mise en place de la seconde feuille. L'assemblage peut être soit pressé à chaud, soit, selon une autre variante, la seconde feuille isolante est appliquée par collage seul sans pressage. Dans ce cas, la seconde feuille peut comporter une couche de matière auto-adhésive sur la face destinée à être appliquée sur la première feuille isolante. Les modules ainsi obtenus sans pressage et après découpage du plateau conservent la forme initiale d'une alvéole du plateau.

Le découpage final des modules est effectué par étampage, par exemple, selon un contour défini par celui d'une alvéole de la première feuille isolante où est logé le composant électronique. Dans le cas d'un module comprenant plusieurs composants, le contour du module englobe plusieurs alvéoles.

La présente invention a aussi comme objet un module électronique comprenant un assemblage d'une première feuille isolante, d'au moins un composant électronique et d'une seconde feuille isolante selon la revendication 11.

Selon une variante, le module peut comporter une couche de matière de remplissage entre la première et la seconde feuille isolante. Cette matière, en général sous forme de résine enrobe le ou les composants électroniques.

L'invention sera mieux comprise grâce à la description détaillée qui va suivre et qui se réfère aux dessins annexés qui sont donnés à titre d'exemple nullement limitatif, dans lesquels:
- la figure 1 représente une vue générale d'un plateau comportant des alvéoles contenant chacune un transpondeur.
- la figure 2 représente une vue en coupe du plateau contenant le transpondeur
- la figure 3 montre une vue en coupe du plateau contenant le transpondeur avec une seconde feuille fermant les alvéoles
- la figure 4 montre une variante de la figure 3 où la seconde feuille est thermo-formée.
- la figure 5 montre une variante à deux plateaux superposés
- la figure 6 montre une variante avec des feuilles supplémentaires.
- la figure 7 montre une vue en coupe de l'assemblage après pressage
- la figure 8 montre une vue en coupe de l'assemblage après pressage avec plusieurs feuilles superposées.

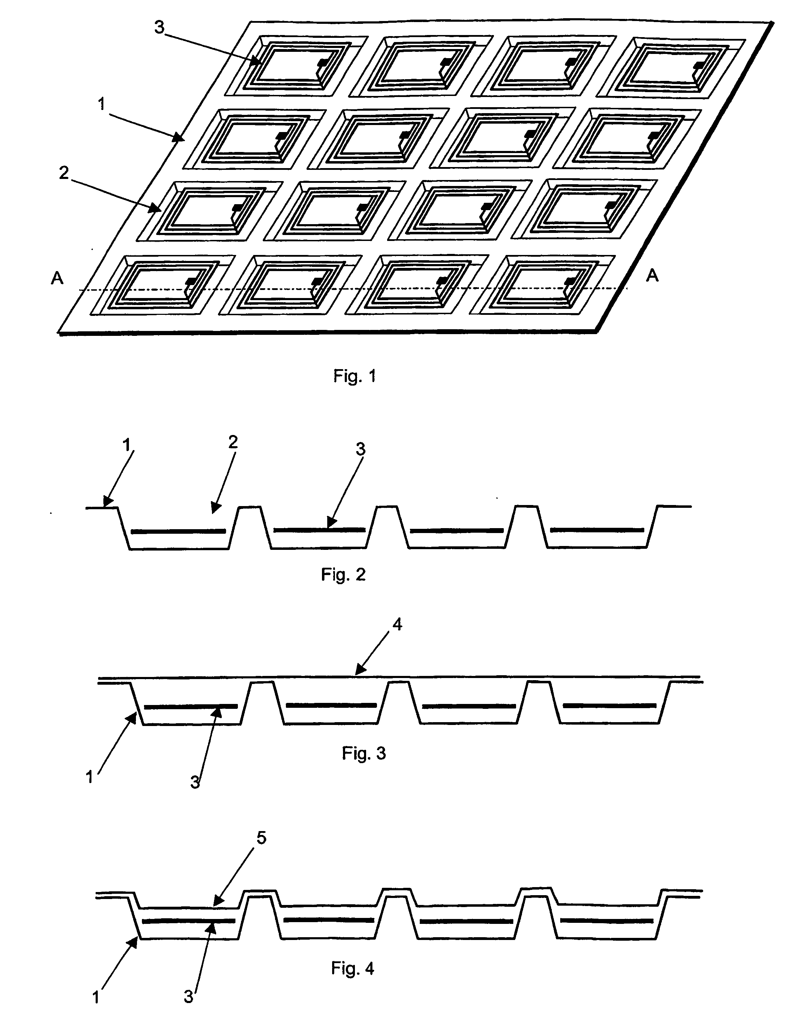

La figure 1 illustre une vue d'ensemble de la première feuille isolante (1) sous la forme d'un plateau constituant l'élément de base pour le conditionnement et la manutention de composants électroniques muni d'alvéoles (2) contenant chacune un transpondeur (3). Les alvéoles (2) sont, en général, adaptées aux dimensions et à la forme de leur contenu. Ce plateau est introduit tel quel avec les composants (3) dans le processus de fabrication des modules. Les deux premières étapes du procédé qui consisteraient, d'une part, à préparer une première feuille puis d'autre part, à déposer les composants de manière précise sur cette feuille sont ainsi supprimées.

La figure 2 montre une coupe selon l'axe A-A du la première feuille isolante (1) dont les alvéoles (2) contiennent le transpondeur (3).

La figure 3 montre la première étape du procédé raccourci qui consiste à superposer une seconde feuille (4) sur la première feuille isolante (1) de façon à fermer toutes les alvéoles (2) contenant un transpondeur (3). Cette seconde feuille peut comporter une couche de matière auto-adhésive sur la face interne appliquée sur la première feuille (1).

Selon une variante du procédé, les alvéoles peuvent être remplis d'une résine avant l'assemblage de la seconde feuille isolante (4) afin d'enrober le composant électronique (3).

La figure 4 illustre une variante ou la seconde feuille (5) comporte des alvéoles obtenues par thermo-formage. Les dimensions de ces alvéoles sont choisies de manière à ce que ces alvéoles puissent s'emboîter dans les alvéoles (2) de l'élément de conditionnement (1) lorsque la seconde feuille (5) est superposée sur la première (1). Cette seconde feuille (5) peut également être un second plateau de manutention de composants électroniques dont les alvéoles sont vides.

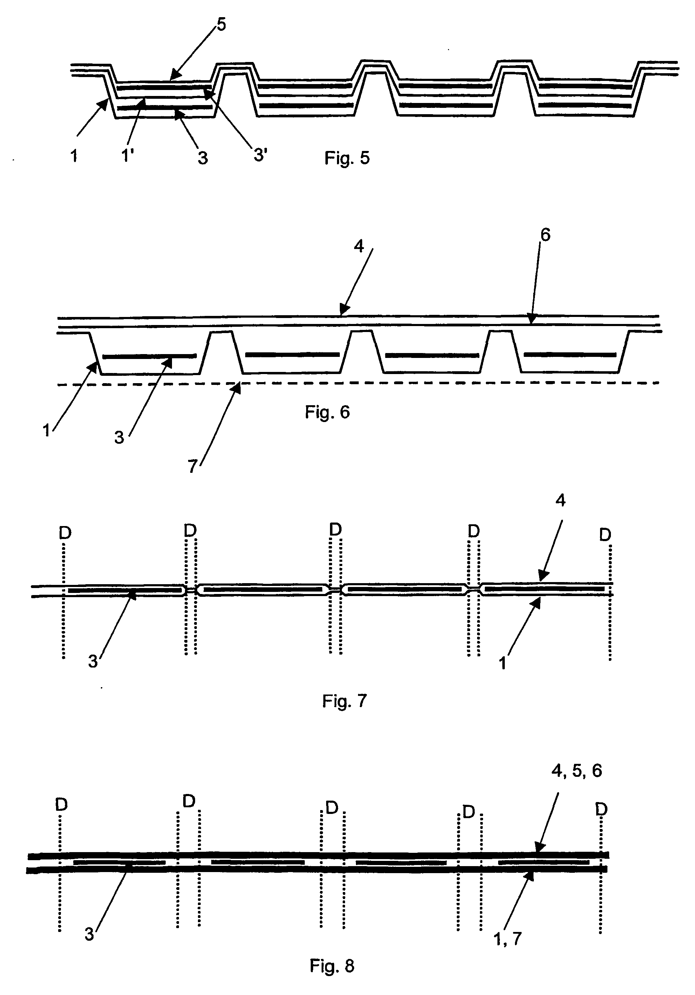

La figure 5 illustre une autre variante où deux plateaux (1, 1') contenant un composant électronique (3, 3') sont superposés. Le second plateau est recouvert par une feuille à alvéoles (5) comme dans la figure 4. Cet exemple montre que plusieurs plateaux contenant des composants peuvent être empilés de façon à ce que les alvéoles s'emboîtent les unes dans les autres. Le dernier plateau est recouvert par une feuille comportant des alvéoles ou non (voir la figure 3). Par exemple, ce type de configuration est utilisé avantageusement pour la fabrication de modules comprenant plusieurs transpondeurs travaillant chacun à une fréquence différente.

La figure 6 montre un exemple de réalisation où une feuille (6) est ajoutée entre l'élément de conditionnement (1) et la seconde feuille (4). Une feuille supplémentaire (7) peut être aussi assemblée sur la face opposée de l'assemblage. Le nombre de feuilles supplémentaires assemblées sur les faces du module n'est pas limité. Elles contribuent à augmenter l'épaisseur et la rigidité du module nécessaires à certaines applications. Les feuilles intermédiaires ou celles assemblées en dernier peuvent comporter un décor ou un marquage permettant l'identification des modules après leur découpage dans la plaque pressée. De plus, l'une ou l'autre des feuilles constituant les faces externes du module final peuvent comporter une couche de matière auto-adhésive servant à coller le module sur la surface d'un support quelconque. Dans ce cas, un tel module constitue, par exemple, une étiquette électronique servant à l'identification d'un objet.

Dans une autre forme de réalisation, les feuilles utilisées (4, 5, 6) peuvent comporter des zones transparentes jouant le rôle de fenêtres rendant tout ou partie du transpondeur ou du composant visible. Dans une variante, certaines feuilles intermédiaires peuvent comporter des ouvertures qui sont, en général, recouvertes par les zones transparentes de feuilles externes ou par des feuilles entièrement transparentes. Ces ouvertures sont pratiquées dans la zone où est situé le composant de façon à le laisser apparaître entièrement, partiellement ou par parties réparties sur la surface du module. Cette propriété permet de distinguer un module à transpondeur authentique d'une imitation ne comportant aucun composant.

Dans la variante où une résine de remplissage est utilisée lors de la fabrication des modules celle-ci sera transparente afin de rendre le ou les composants électroniques visibles.

Cet aspect de sécurité est exploité, par exemple, dans les applications de contrôle d'accès où les modules servent de tickets, de badges ou de cartes prépayées. De plus un marquage adéquat, hologramme, logos, etc. permet de renforcer la protection des modules contre le piratage.

La figure 7 illustre l'assemblage après le pressage à chaud de la feuille de base (1), des transpondeurs (3) et de la feuille de recouvrement (4). Le produit ainsi obtenu est une plaque mince formée par la juxtaposition des deux feuilles (1, 4) entre lesquelles sont noyés les transpondeurs (3). Les modules électroniques sont ensuite découpés dans la plaque selon un contour prédéfini dans les zones (D) séparant les alvéoles. Les feuilles épousent la forme des composants après pressage à cause de leur faible épaisseur. Ce type de réalisation convient par exemple pour des étiquettes électroniques destinées à être collées sur des objets.

La figure 8 illustre un assemblage après le pressage à chaud de plusieurs feuilles superposées sur chaque face (1, 4, 5, 6, 7), entre lesquelles se trouvent des transpondeurs (3). Le produit ainsi obtenu est une plaque épaisse, rigide à faces sensiblement planes. Cette réalisation s'applique par exemple à la fabrication de badges, de clés ou de cartes électroniques.

Toutes les feuilles isolantes utilisées dans le procédé de fabrication des modules peuvent comporter des orifices (trous, fentes) et/ou des structures à reliefs (rainures, canaux, gaufrage) servant à l'évacuation de l'air emprisonné dans les alvéoles lors des opérations de pressage. En effet, l'air s'échappe par les orifices et/ou latéralement par les bords de la plaque grâce aux structures à reliefs, ce qui évite la formation de bulles indésirables sur la surface des modules.

Dans la variante où une résine de remplissage est utilisée lors de la fabrication des modules, les orifices ou les structures à reliefs des feuilles isolantes servent aussi à l'évacuation du surplus de résine hors des alvéoles lors du pressage.

## Revendications

1. Procédé de fabrication d'un module électronique comprenant au moins un composant électronique (3) transporté sur un plateau servant à la manutention de composants électroniques (3) et comportant des alvéoles (2), et d'une seconde feuille isolante **caractérisé par** les étapes suivantes:
- poser sur une surface de travail le plateau alvéolaire formant une première feuille isolante (1), lesdites alvéoles (2) contenant chacune au moins un composant électronique (3),
- superposer la seconde feuille isolante (4) sur la première de manière à fermer les alvéoles (2) contenant le composant électronique (3),
- découper les modules suivant un contour englobant au moins une alvéole (2) de la première feuille isolante (1).

2. Procédé selon la revendication 1 **caractérisé en ce que** la seconde feuille isolante (4) comporte une couche de matière auto-adhésive sur la face destinée à être appliquée sur la première feuille isolante (1).

3. Procédé selon la revendication 1 **caractérisé en ce qu'**une étape de pressage à chaud de l'assemblage constitué par la superposition de la seconde feuille isolante (4) sur la première feuille isolante (1) est effectuée au moyen d'une plaque de pressage appliquée sur la seconde feuille isolante (4).

4. Procédé selon les revendications 1, 2 ou 3 **caractérisé en ce qu'**une matière de remplissage est introduite dans les alvéoles contenant le composant électronique avant la superposition de la seconde feuille isolante (4), ladite matière enrobant le composant électronique.

5. Procédé selon les revendications 1, 2, 3 ou 4 **caractérisé en ce que** la seconde feuille isolante comporte des alvéoles, lesdites alvéoles s'emboîtant dans les alvéoles (2) de la première feuille isolante (1) lors de la superposition de la seconde feuille sur la première (1),

6. Procédé selon la revendication 5 **caractérisé en ce que** la seconde feuille (5) constitue un second plateau de manutention de composants électroniques (3) dont les alvéoles sont dépourvus de composants électroniques.

7. Procédé selon les revendications 1 à 6 **caractérisé en ce qu'**au moins une feuille supplémentaire (6, 7) est placée sur la première et/ou sur la seconde feuille (4, 5) ladite feuille supplémentaire faisant office de décor et/ou de renforcement du module.

8. Procédé selon la revendication 1 **caractérisé en ce qu'**une pluralité de plateaux alvéolaires (1, 1') contenant des composants électroniques (3, 3') est empilée, les alvéoles (2) d'un plateau s'emboîtant dans les alvéoles du plateau placé précédemment, ledit empilement est recouvert par une feuille (4, 5) fermant les alvéoles du dernier plateau de la pile.

9. Procédé selon la revendication 3 **caractérisé en ce que** les feuilles constituant l'assemblage comportent des orifices et/ou des structures à reliefs, lesdits orifices et/ou structures assurant l'évacuation de l'air emprisonné dans les alvéoles (2) lors de l'opération de pressage.

10. Procédé selon les revendications 3 et 9 **caractérisé en ce que** les orifices et/ou des structures à reliefs assurent l'évacuation du surplus de matière de remplissage hors des alvéoles (2) lors de l'opération de pressage.

11. Module électronique comprenant un assemblage d'une première feuille isolante (1), d'au moins un composant électronique (3) et d'une seconde feuille isolante (4, 5) **caractérisé en ce que** la première feuille isolante (1) est constituée d'une partie d'un plateau alvéolaire de manutention de composants électroniques, ladite partie comportant au moins une alvéole (2) contenant chacune au moins un composant électronique (3).

12. Module selon la revendication 11 **caractérisé en ce qu'**il comporte une couche de matière de remplissage entre la première et la seconde feuille isolante, ladite matière enrobant le ou les composants électroniques (3).

13. Module selon les revendications 11 et 12 **caractérisé en ce qu'**au moins une feuille supplémentaire (5, 6, 7) est assemblée sur une et/ou l'autre face du module, ladite feuille supplémentaire pouvant comporter un décor.

14. Module selon les revendications 11 à 13 **caractérisé en ce que** la seconde feuille isolante est constituée d'une partie d'un second plateau alvéolaire de manutention de composants électroniques, les alvéoles de ladite seconde feuille étant emboîtés dans les alvéoles de la première feuille sont dépourvus de composants électroniques.

15. Module selon les revendications 11 à 14 comprenant un empilement de feuilles isolantes (1, 1') constituées de parties de plateaux alvéolaires de manutention de composants électroniques, les alvéoles desdits plateaux étant emboîtées les unes dans les autres contiennent chacune un composant (3, 3'), la dernière feuille de l'empilement étant recouverte par une seconde feuille (4, 5).

16. Module selon la revendication 11 **caractérisé en ce** l'une et/ou l'autre desdites feuilles isolantes (1, 4) peut comporter un décor faisant office de marquage d'identification du module.

17. Module selon les revendications 11 à 16 **caractérisé en ce que** les épaisseurs des feuilles isolantes (1, 4, 5, 6, 7) déterminent l'épaisseur et la rigidité finale du module.

18. Module selon les revendications 11 à 17 **caractérisé en ce que** les feuilles isolantes (1, 4, 5, 6, 7) comportent des orifices et/ou des structures à reliefs destinés à l'évacuation de l'air et/ou du surplus de matière de remplissage pendant l'opération de pressage effectuée lors de la fabrication du module.

19. Module selon les revendications 11 à 18 **caractérisé en ce que** les feuilles isolantes (1, 4, 5, 6, 7) comportent des zones transparentes jouant le rôle de fenêtres rendant tout ou partie du composant électronique (3) visible, ladite visibilité du composant permettant l'authentification du module.

20. Module selon les revendications 12 à 19 **caractérisé en ce que** la matière de remplissage est transparente assurant la visibilité de ou des composants électroniques.

21. Module selon les revendications 11 à 20 **caractérisé en ce que** les feuilles isolantes (1, 4, 5, 6, 7) comportent des ouvertures dans la zone où est situé le composant électronique (3), lesdites ouvertures étant recouvertes par les zones transparentes de la feuille supplémentaire (5, 6, 7), lesdites zones pouvant couvrir toute ou parties de la feuille supplémentaire et constituent des fenêtres laissant apparaître tout ou partie du composant électronique (3), ladite feuille supplémentaire étant appliquée sur une et/ou l'autre des faces du module.

22. Module selon les revendications 11 à 21 **caractérisé en ce que** l'une des feuilles isolantes, constituant les faces externes du module, comporte une couche de matière auto-adhésive destinée à la fixation du module sur la surface d'un support.

## Patentansprüche

1. Verfahren zur Fertigung eines elektronischen Moduls, der zumindest ein elektronisches Bauteil (3), das auf einer Platte transportiert wird, die der Aufbewahrung von elektronischen Bauteilen (3) dient und Zellen (2) aufweist, sowie eine zweite isolierende Folie umfasst, durch die folgenden Schritte **gekennzeichnet**:
- auf eine Arbeitsfläche die Platte mit den Zellen zu legen, die eine erste isolierende Folie (1) bildet, wobei diese Zellen (2) zumindest je ein elektronisches Bauteil (3) enthalten,
- die zweite isolierende Folie (4) so auf die erste aufzulegen, dass die das elektronische Bauteil (3) enthaltenden Zellen (2) verschlossen werden,
- die Modulen entlang einer Kontur herauszuschneiden, die zumindest eine Zelle (2) der ersten isolierenden Folie (1) einschliesst.

2. Verfahren nach Anspruch 1, **dadurch gekennzeichnet, dass** die zweite isolierende Folie (4) auf der Seite, die dazu bestimmt ist, auf die erste isolierende Folie (1) aufgebracht zu werden, eine Schicht aus selbstklebendem Material aufweist.

3. Verfahren nach Anspruch 1, **dadurch gekennzeichnet, dass** ein Schritt des Heisspressens des Verbandes, der durch Auflegen der zweiten isolierenden Folie (4) auf die erste isolierende Folie (1) gebildet wird, mit einer auf die zweite isolierende Folie (4) aufgedrückten Pressplatte ausgeführt wird.

4. Verfahren nach Anspruch 1, **dadurch gekennzeichnet, dass** vor Auflegen der zweiten isolierenden Folie (4) ein Füllmaterial in die Zellen eingeführt wird, die das elektronische Bauteil enthalten, wobei dieses Material das elektronische Bauteil einhüllt.

5. Verfahren nach Anspruch 1, **dadurch gekennzeichnet, dass** die zweite isolierende Folie Zellen aufweist, wobei sich diese Zellen beim Auflegen der zweiten isolierenden Folie auf die erste (1) in die Zellen (2) der ersten isolierenden Folie (1) einpassen.

6. Verfahren nach Anspruch 5, **dadurch gekennzeichnet, dass** die zweite Folie (5) eine zweite Platte für die Aufbewahrung von elektronischen Bauteilen (3) darstellt, deren Zellen von elektronischen Bauteilen frei sind.

7. Verfahren nach Anspruch 1, **dadurch gekennzeichnet, dass** zumindest eine zusätzliche Folie (6, 7) auf die erste und/oder die zweite Folie (4, 5) gelegt wird, wobei diese zusätzliche Folie der Verzierung und/oder der Verstärkung des Moduls dient.

8. Verfahren nach Anspruch 1, **dadurch gekennzeichnet, dass** eine Mehrzahl von Platten (1, 1') mit Zellen, die elektronische Bauteile (3, 3') enthalten, übereinander gestapelt wird, wobei sich die Zellen (2) einer Platte in die Zellen der zuvor ausgelegten Platte einpassen und der Stapel von einer Folie (4, 5) überdeckt wird, die, die Zellen der letzten Platte des Stapels verschliesst.

9. Verfahren nach Anspruch 3, **dadurch gekennzeichnet, dass** die den Verband bildenden Folien Öffnungen und/oder profilierte Strukturen aufweisen, wobei diese Öffnungen und/oder Strukturen das Entweichen der in den Zellen (2) eingeschlossenen Luft während des Pressschritts gewährleisten.

10. Verfahren nach Anspruch 9, **dadurch gekennzeichnet, dass** die Öffnungen und/oder profilierten Strukturen den Abfluss überschüssigen Füllmaterials aus den Zellen (2) während des Pressschritts gewährleisten.

11. Elektronischer Modul, einen Verband aus einer ersten isolierenden Folie (1), zumindest einem elektronischen Bauteil (3) und einer zweiten isolierenden Folie (4, 5) umfassend und **dadurch gekennzeichnet, dass** die erste isolierende Folie (1) aus einem Abschnitt einer Platte für die Aufbewahrung von elektronischen Bauteilen besteht, wobei dieser Abschnitt zumindest eine Zelle (2) aufweist, die je zumindest ein elektronisches Bauteil (3) enthält.

12. Modul nach Anspruch 11, **dadurch gekennzeichnet, dass** er zwischen der ersten und zweiten isolierenden Folie eine Schicht von Füllmaterial aufweist, wobei dieses Material das oder die elektronischen Bauteile (3) umhüllt.

13. Modul nach Anspruch 11, **dadurch gekennzeichnet, dass** zumindest eine zusätzliche Folie (5, 6, 7) auf der einen und/oder anderen Aussenseite des Moduls angefügt ist, wobei diese zusätzliche Folie eine Verzierung aufweisen kann.

14. Modul nach Anspruch 11, **dadurch gekennzeichnet, dass** die zweite isolierende Folie aus einem Abschnitt einer zweiten Platte mit Zellen für die Aufbewahrung von elektronischen Bauteilen besteht, wobei die Zellen dieser zweiten Folie, die in die Zellen der ersten Folie eingepasst sind, von elektronischen Bauteilen frei sind.

15. Modul nach Anspruch 11, einen Stapel von isolierenden Folien (1, 1') umfassend, die aus Abschnitten von Platten mit Zellen für die Aufbewahrung von elektronischen Bauteilen bestehen, wobei die Zellen dieser Platten, die ineinander eingepasst sind, je ein Bauteil (3, 3') enthalten und die letzte Folie des Stapels von einer zweiten Folie (4, 5) überdeckt wird.

16. Modul nach Anspruch 11, **dadurch gekennzeichnet, dass** die eine und/oder die andere der isolierenden Folien (1, 4) eine Verzierung aufweist, die einer identifizierenden Markierung des Moduls dient.

17. Modul nach einem der Ansprüche 11 bis 16, **dadurch gekennzeichnet, dass** die Dicken der isolierenden Folien (1, 4, 5, 6, 7) die endgültige Dicke und Starrheit des Moduls bestimmen.

18. Modul nach einem der Ansprüche 11 bis 16, **dadurch gekennzeichnet, dass** die isolierenden Folien (1, 4, 5, 6, 7) Öffnungen und/oder profilierte Strukturen aufweisen, die für den Austritt von Luft und/oder überschüssigem Füllmaterial während des Pressschritts, der bei der Modulherstellung ausgeführt wird, bestimmt sind.

19. Modul nach einem der Ansprüche 11 bis 16, **dadurch gekennzeichnet, dass** die isolierenden Folien (1, 4, 5, 6, 7) durchsichtige Bereiche aufweisen, die als Fenster wirken, um das ganze oder einen Teil des elektronischen Bauteils (3) sichtbar zu machen, wobei die Sichtbarkeit des Bauteils die Authentisierung des Moduls ermöglicht.

20. Modul nach Anspruch 12, **dadurch gekennzeichnet, dass** das Füllmaterial durchsichtig ist und die Sichtbarkeit des oder der elektronischen Bauteile gewährleistet.

21. Modul nach einem der Ansprüche 11 bis 16, **dadurch gekennzeichnet, dass** die isolierenden Folien (1, 4, 5, 6, 7) in dem Bereich, wo sich das elektronische Bauteil (3) befindet, Öffnungen aufweisen, wobei diese Öffnungen von den durchsichtigen Bereichen der zusätzlichen Folie (5, 6, 7) überdeckt sind, diese Bereiche sich über die ganze oder einen Teil der zusätzlichen Folie erstrecken können und Fenster darstellen, die das ganze oder einen Teil des elektronischen Bauteils (3) sichtbar werden lassen, und die zusätzliche Folie auf einer und/oder der anderen Aussenseite des Moduls aufgebracht ist.

22. Modul nach Anspruch 11, **dadurch gekennzeichnet, dass** die eine der isolierenden Folien, die, die Aussenseiten des Moduls bilden, eine Schicht aus selbstklebendem Material aufweist, die für die Befestigung des Moduls auf der Oberfläche eines Trägers bestimmt ist.

## Claims

1. Method for manufacturing an electronic module having at least one electronic component (3) transported on a tray made for the handling of electronic components and comprising cells (2), and a second insulating sheet **characterized by** the following steps:
- placing the cells tray forming a first insulating sheet (1) on a work surface, said cells (2) containing each at least one electronic component (3),
- superimposing the second insulating sheet (4) onto the first in such a way as to close the cells (2) containing the electronic component (3),
- cutting the modules according to an outline including at least one cell (2) of the first insulating sheet (1).

2. Method according to claim 1 **characterized in that** the second insulating sheet (4) includes a layer of auto-adhesive material on the face intended to be applied onto the first insulating sheet (1).

3. Method according to claim 1 **characterized in that** a step of hot pressing of the assembly constituted by the superimposing of the second insulating sheet (4) onto the first insulating sheet (1) is carried out by means of a pressing plate applied onto the second insulating sheet (4).

4. Method according to claim 1 **characterized in that** a filling material is introduced into the cells containing the electronic component before the superposition of the second insulating sheet (4), said material encapsulating the electronic component.

5. Method according to claim 1 **characterized in that** the second insulating sheet includes cells, said cells fitting into the cells (2) of the first insulating sheet (1) at the time of superimposing the second sheet onto the first one (1),

6. Method according to claim 5 **characterized in that** the second sheet (5) constitutes a second tray of electronic components (3) whose cells are free of electronic components.

7. Method according to claim 1 **characterized in that** at least one supplementary sheet (6, 7) is placed onto the first and/or second sheet (4, 5) said supplementary sheet serving as decoration and/or reinforcement of the module.

8. Method according to claim 1 **characterized in that** a plurality of cells trays (1, 1') containing electronic components (3, 3') is stacked, the cells (2) of a tray fit into the cells of the previously placed tray, said stack is covered by a sheet (4, 5) closing the cells of the last tray of said stack.

9. Method according to claim 3 **characterized in that** the sheets constituting the assembly include openings and/or relief structures, said openings and/or structures assuring the evacuation of the air imprisoned in the cells (2) during the pressing operation.

10. Method according to claim 9 **characterized in that** the openings and/or relief structures assure the evacuation of the surplus filling material out of the cells (2) during the pressing operation.

11. Electronic module comprising an assembly of a first insulating sheet (1), of at least one electronic component (3) and of a second insulating sheet (4, 5) **characterized in that** the first insulating sheet (1) is constituted by a part of a tray of electronic components handling, said part including at least one cell (2), containing each at least one electronic component (3).

12. Module according to claim 11 **characterized in that** it includes a layer of filling material between the first and the second insulating sheet, said material encapsulating the electronic component / s (3).

13. Module according to claim 11 **characterized in that** at least one supplementary sheet (5, 6, 7) is assembled on one and/or the other face of the module, said supplementary sheet being able to include a decoration.

14. Module according to claim 11 **characterized in that** the second insulating sheet is constituted by a part of a second tray of electronic components handling, the cells of said second sheet being inserted into the cells of the first sheet are free of electronic components.

15. Module according to claim 11 including a stack of insulating sheets (1, 1') constituted by parts of trays of electronic components handling, the cells of said trays being inserted into each other containing each a component (3, 3'), the last sheet of the stack being covered by a second sheet (4, 5).

16. Module according to claim 11 **characterized in that** one and/or the other of said insulating sheets (1, 4) include a decoration serving as an identification mark of the module.

17. Module according to any one of claims 11 to 16 **characterized in that** the thickness of the insulating sheets (1, 4, 5, 6, 7) determines the final thickness and rigidity of the module.

18. Module according to any one of claims 11 to 16 **characterized in that** the insulating sheets (1, 4, 5, 6, 7) include openings and/or relief structures intended for the evacuation of air and/or the surplus filling material during the pressing operation carried out when the module is manufactured.

19. Module according to any one of claims 11 to 16 **characterized in that** the insulating sheets (1, 4, 5, 6, 7) include transparent areas playing the role of windows allowing all or part of the electronic component (3) to be visible, said visibility of the component permitting authentication of the module.

20. Module according to claim 12 **characterized in that** the filling material is transparent assuring the visibility of the electronic component / s.

21. Module according to any one of claims 11 to 16 **characterized in that** the insulating sheets (1, 4, 5, 6, 7) include openings in the area where the electronic component (3) is located, said openings being covered by the transparent areas of the supplementary sheet (5, 6, 7), said areas being able to cover all or parts of the supplementary sheet and constituting the windows letting all or part of the electronic component (3) appear, said supplementary sheet being applied onto one and/or the other faces of the module.

22. Module according to claim 11 **characterized in that** one of the insulating sheets, constituting the external faces of the module, includes a layer of auto-adhesive material destined to fix the module onto the surface of a support.
